Europäisches Patentamt

European Patent Office

Office européen des brevets

(11) Publication number: **0 095 200**
**B1**

(12) **EUROPEAN PATENT SPECIFICATION**

(45) Date of publication of patent specification: **15.03.89**

(21) Application number: **83200657.1**

(22) Date of filing: **06.05.83**

(51) Int. Cl.⁴: **H 01 J 37/32**

(54) Plasma reactor removeable insert.

(30) Priority: **21.05.82 US 380591**

(43) Date of publication of application:
**30.11.83 Bulletin 83/48**

(45) Publication of the grant of the patent:
**15.03.89 Bulletin 89/11**

(84) Designated Contracting States:
**DE FR GB IT NL**

(56) References cited:
**EP-A-0 019 370**
**GB-A-2 055 329**

(73) Proprietor: **TEGAL CORPORATION**
**11 Digital Drive**
**Novato California 94947 (US)**

(72) Inventor: **Hoog, Josef T.**
**430 Marin Oakes Drive**
**Novato California 94947 (US)**
Inventor: **Mitzel, James W.**
**3415 Clearfield Avenue**
**Richmond California 94803 (US)**

(74) Representative: **Ibbotson, Harold**
**Motorola Ltd Patent and Licensing Operations -**
**Europe Jays Close Viables Industrial Estate**
**Basingstoke Hampshire RG22 4PD (GB)**

Courier Press, Leamington Spa, England.

# Description

This invention relates to plasma reactor equipment and, in particular, to the construction of a readily assembled and disassembled reactor.

## Background

In the prior art, plasma reactors come in a variety of shapes, e.g. parallel plate and barrel types, and a variety of capacities, e.g. single wafer and batch. Typically, the reactor comprises a quartz, aluminium, or stainless steel chamber with aluminium electrodes positioned therein. In a recent advance in the art, as described in U.S. Patent 4,209,357 and related EP—A—0 019 370, a single wafer, parallel plate reactor is provided with an interior or upper plasma electrode which serves both as an RF (radio frequency) electrode and as a gas manifold. While providing increased uniformity and other advantages, the reactor is expensive to make due to the precise machining and alignment of the various parts which make up the electrode/manifold.

The processes run in plasma reactors have become more complex and use a variety of gases. As is known, a plasma contains the source gas or gases as well as intermediate products and byproducts. Sometimes a successful process is obtained by only slight shifts in the chemical balance in the reactor. A problem exists in that the chemicals used or found in a process can chemically attack the materials used to make the chamber. Another problem is that the chamber, particularly the electrodes, is subject to physical attack by the plasma, e.g. what is known as back sputtering. Yet another problem is that certain materials react to form coatings on parts of the chamber, particularly the electrodes. These three problems combine for a fourth wherein subsequent operations, particularly with different chemicals, cause deposits or materials from the chamber to deposit on the semiconductor wafer therein, contaminating it, or to upset the chemical balance of the reaction.

These problems can be minimized by careful choice of materials and reagents, as well as routine cleaning of the chamber. This makes ease of assembly and disassembly an important feature of a reactor, both for cleaning and for changing at least the electrode materials.

In view of the foregoing, it is therefore an object of the present invention to provide an improved plasma reactor which is more easily assembled and disassembled with readily removable electrodes.

## Summary

Accordingly, the present invention provides a plasma reactor having a frame member in the form of a plate having an aperture therein:

a concave member, the rim of which is removably attached to a first major surface of the frame member so as to surround the said aperture;

a first electrode arranged within, and electrically connected to, said concave member parallel to said frame member, the transverse dimensions of said first electrode being smaller than the corresponding transverse dimensions of said aperture;

retaining means attached to said concave member for holding said first electrode in place;

closure means having a second electrode attached thereto, and suitable to be approached to said concave member from the opposite side of said frame member in order to define with the concave member a hermetically sealed chamber, within which said first and second electrodes define a space bounded by two plane and parallel opposing surfaces;

means for supplying RF energy to at least one of said electrodes;

characterized in that the first electrode is removable from said concave member via the aperture in said frame member while said concave member and said frame member remain attached; and that the interior of said concave member comprises a broad, shallow counterbore having a circumferential shoulder, against which abuts a first major surface of a first electrode, so as to define with concave member a first cavity, the said first cavity communicating with the outer surface of the concave member by at least one passageway, and with the said space via at least one through-bore, for the supply of gas to said space; and that the concave member incorporates a second cavity and a plurality of passageways connecting the said second cavity with the inner surface of the concave member at respective locations outside the said first cavity, the said second cavity also communicating with the outer surface of the concave member for the removal of gas from the said space.

A more complete understanding of the present invention can be obtained by considering the following detailed description in conjunction with the accompanying drawings, in which:

Fig. 1 illustrates a plasma reactor in accordance with the prior art.

Fig. 2 illustrates a preferred embodiment of a plasma reactor in accordance with the present invention.

Fig. 3 illustrates an alternative embodiment of a plasma reactor in accordance with the present invention.

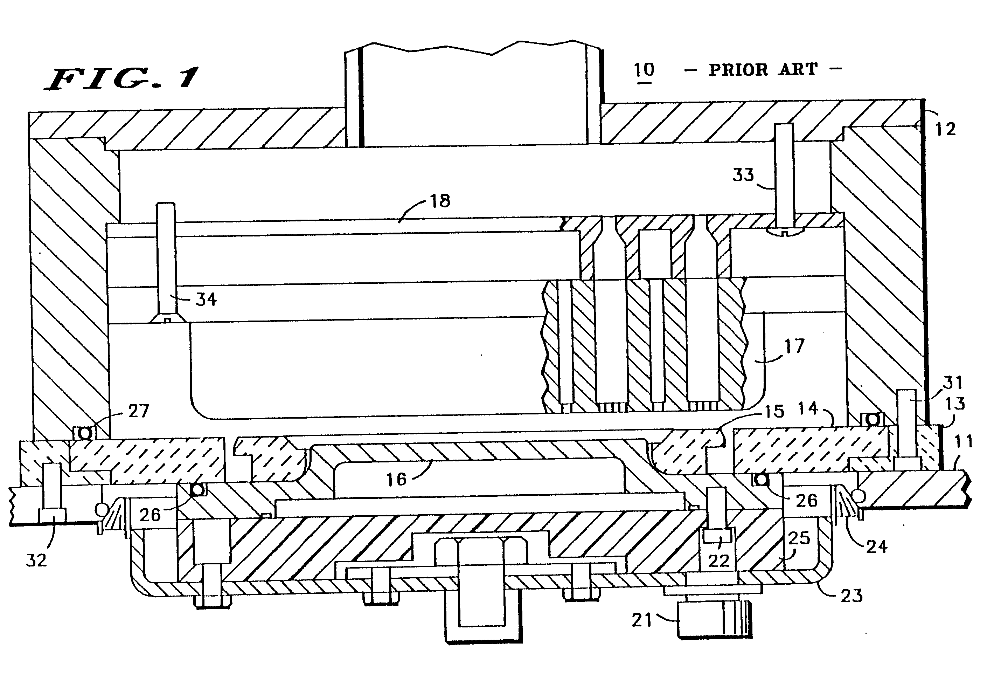

Fig. 1 illustrates, in slightly more detail, the construction of the plasma reactor described in U.S. Patent 4,209,357. Specifically, reactor 10 comprises a frame 11 to which is fastened chamber body 12, retaining ring 13, and isolation ring 14. Wafer ring 15, which typically comprises a ceramic, sits atop lower electrode 16 which forms the closure mechanism for the reactor. Lower electrode 16 is RF hot and receives the RF energy from connector 21 and attachment bolt 22. RF connector 21 comprises a coaxial cable, the outer portion of which is connected to RF shield 23. Frame 11 comprises an enlarged bore through which the lower electrode assembly passes. Interconnecting RF shield 23 and frame 11 are a plurality of conductive fingers 24, suitably disposed about the interior of the bore in frame 11. RF shield 23 is isolated from lower electrode 16 by isolation disc 25. A suitable seal, such as O-ring 26, seals lower electrode 16 to isolation ring 14, thereby sealing the enclosed volume of the reactor. Within the reactor volume, the interior or upper electrode assembly comprises an upper electrode 17 and a manifold plate 18.

In assembling a reactor constructed as illustrated in Fig. 1, manifold plate 18 is fastened to chamber body 12 by fasteners 33 suitably positioned around the periphery thereof. Similarly, upper electrode 17 is fastened to manifold plate 18 by another plurality of fastening means such as bolt 34. Isolation ring 14 is temporarily held in place while retaining ring 13 is secured to chamber body 12 by another plurality of fastening means such as bolt 31. The thus completed chamber assembly is then fastened to a frame 11 by way of another plurality of bolts 32. Typically, eight or more bolts are used for each plurality.

Manifold plate 18 is rarely flat after being attached to chamber body 12. The machining of the plurality of apertures and channels in manifold plate 18 causes distortions thereof. Further, improper torque on bolts 33 which attach plate 18 to chamber 12 may cause further distortions in plate 18. In assembling the reactor illustrated in Fig. 1 the torque applied to bolts 33 and 34 are used to correct for any non-planarities in electrode 17, which must be planar and uniformly spaced from lower electrode 16. Also, the passageways in upper electrode 17 and manifold plate 18 must be carefully aligned.

As can be appreciated from the foregoing, the reactor of Fig. 1, while providing improvements over prior art reactors, is difficult to disassemble, clean, and reassemble quickly. Further, the metal to metal contact between upper electrode 17 and manifold plate 18 must be carefully maintained across the entire area of contact to prevent leakage or mixing of supply and exhaust gases. Further, the reduced diameter portion of upper electrode 17, which provides clearance for bolts 34, causes a plasma region which is not as well defined as desired due to the large volume around the sides of upper electrode 17. Also, during disassembly of reactor 10 virtually all seals for the chamber must be broken, not only large seals 26 and 27 but also the plurality of smaller seals associated with the reactor such as the water and gas seals. It is particularly the smaller seals, which are not intended to be made and broken repeatedly, that may cause difficulty in operating the reactor.

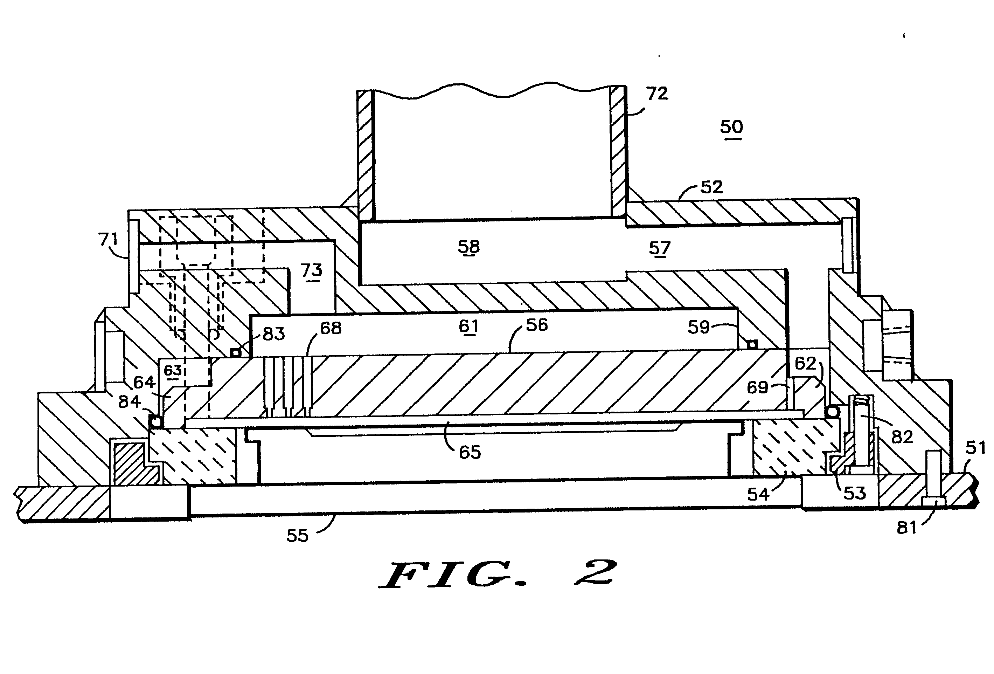

These disadvantages are overcome with the reactor illustrated in Fig. 2. Specifically, reactor 50 comprises a frame 51 to which chamber body or concave member 52 is attached by a plurality of fastening means such as bolt 81. Typically, depending upon the diameter of the concave member, eight to twelve bolts would be used to fasten concave member 52 to frame 51. Within concave member 52, a plurality of passageways 57 communicate with a central cavity 58 through which gases are typically exhausted by member 72 which is connected to a suitable vacuum pump. Also, within concave member 52 is passageway 73 which communicates to the outside of concave member 52 by way of connection fitting 71. A source of one or more gases is connected to fitting 71. Alternatively, a plurality of passageways 73 can be provided so that the interior of concave member 52 acts as the mixing chamber. Concave member 52 forms a broad, shallow counterbore having shoulders 59.

Upper electrode 56 is abutted against shoulders 59 to form cavity 61 within concave member 52. The electrode is plain, i.e. characterized by the absence of any means for fastening it, e.g. enlarged bores for bolts, threaded portions or the like. Electrode 56 must be held in place by another, appropriately shaped member which is adapted for being fastened to concave member 52. As illustrated in Figure 2, isolation ring 54 holds electrode 56 in place and retaining ring 53 is attached to concave member 52, fastening both electrode 56 and isolation ring 54.

Upper electrode 56 comprises a plurality of bores such as bores 68 which communicate from one major surface of electrode 56 to the other in a predetermined pattern across the central area of electrode 56. The lower surface of electrode 56, in turn, preferably comprises a large shallow counterbore defined by annular shoulder 64 which determines the spacing between the major surface of electrode 56 and lower electrode assembly 55. Lower electrode assembly 55 is not shown in detail as its construction can be similar to the construction of the lower electrode assembly described in Fig. 1. When the reactor is closed, i.e. when electrode assembly 55 is positioned as shown, chamber 65 is formed above lower electrode assembly and is the volume in which the plasma is formed.

Around the peripheral portion of electrode 56 is formed a plurality of bores 69 which communicates with passageway 57. In a preferred embodiment of the present invention, the periphery of electrode 56 is of reduced thickness to form an annular chamber 63 between shoulder 62 and concave member 52. Annular chamber 63 communicates by way of passageways 57 with cavity 58. In so doing, it is not necessary to align bores 69 with corresponding portions of passageways 57, thereby considerably simplifying the construction of a plasma reactor in accordance with the present invention.

Reactor 50 is readily disassembled by opening the chamber, and removing bolts 82, of which there are typically eight. Retaining ring 53 is removed and isolation ring 54 is removed. This done, electrode 56 is then simply removed and the disassembly process is completed. Thus, it is not necessary to remove concave member 52 from frame 51 nor is it necessary to break the plurality of seals for vacuum, gas, and water lines. O-ring seals 83 and 84 are intended for opening and closing and, even if worn, are readily replaced. Further, there is no metal to metal seal as in the chamber of the prior art. In addition, fastening members 82 are all outside the seal formed by O-ring 84 and thus can comprise any suitable material for fastening members, since they are not subject to attack by the plasma.

Thus it is apparent to those of skill in the art that the construction of chamber 50 is considerably simplified from that of the prior art, not only in the number of fasteners used but also in their location. Further, the construction of the electrode is simplified and the sealing of the chamber is also simplified. In addition, the seals for vacuum, gas, and water lines need not be broken each time the reactor is diassembled, thereby increasing the reliability of each of those joints. Also, the upper electrode has a greater area in contact with the concave member, thereby improving the heat sinking of the electrode and increasing the temperature control of the electrode.

Electrode 56 may comprise any suitable material and may readily be interchanged with other electrodes of the same outline, for example, to vary the spacing between electrode 56 and lower electrode assembly 55. This is readily accomplished by changing the depth of the counterbore, i.e. the height of shoulder 64. Further, electrode 56 may comprise any suitable material appropriate for the particular reaction taking place. For example, the most commonly used material is aluminium. However, materials such as anodized aluminium or stainless steel can also be used. In addition, electrode 56 can have the lower major surface thereof coated with a suitable material to either enhance the plasma reaction or to help electrode 56 withstand the plasma within chamber 65.

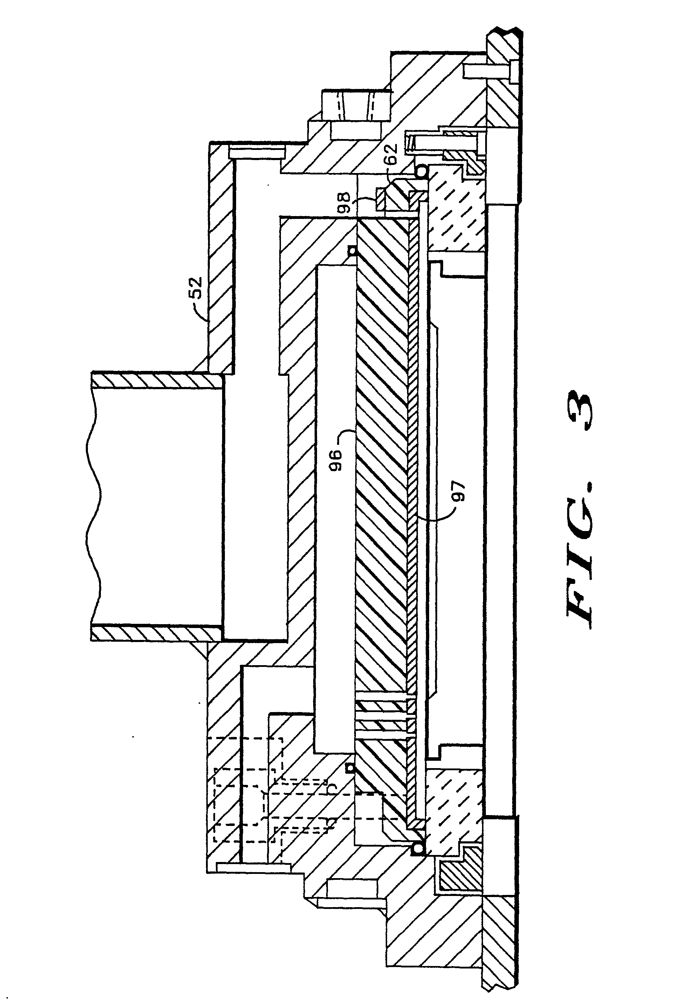

Alternatively, as illustrated in Fig. 3, electrode 96 may comprise a non-metallic member having a metal coating 97 formed thereon. In this case, it is necessary for metal layer 97 to be electrically connected with concave member 52. This can be accomplished a number of ways, such as forming a conductive layer 98 on the upper portion of shoulder 62 for engaging a suitable contact (not shown) connected to a nearby portion of concave member 52. Conductive layers 97 and 98 are readily connected by a conductor in one or more of bores 69. In so doing, one obtains a plasma electrode which is much less expensive to produce and can be disposed of rather than cleaned, if desired. As an example, but not by way of limitation, electrode 96 may comprise acetal plastic (Delrin), polytetrafluoroethylene plastic (Teflon), or ceramic, e.g. alumina, having a coating of aluminium formed thereon.

There is thus provided by the present invention an improved plasma reactor which is substantially simpler to construct and maintain and, in addition, enables one to interchange electrodes to obtain the most compatible materials for the particular process being accomplished.

Having thus described the invention it will be apparent to those of skill in the art that various modifications may be made within the scope of the present invention. For example, while illustrated in a preferred embodiment as a single wafer, parallel plate reactor for processing semiconductor wafers, it is understood that any article or plurality of articles may be processed in a reactor in accordance with the present invention.

## Claims

1. A plasma reactor having a frame member (51) in the form of a plate having an aperture therein;

a concave member (52), the rim of which is removably attached to a first major surface of the frame member (51) so as to surround the said aperture;

a first electrode (56) arranged within, and electrically connected to, said concave member (52) parallel to said frame member (51), the transverse dimensions of said first electrode being smaller than the corresponding transverse dimensions of said aperture;

retaining means (53, 54) attached to said concave member (52) for holding said first electrode (56) in place;

closure means (55) having a second electrode attached thereto, and suitable to be approached to said concave member (52) from the opposite side of said frame member (51) in order to define with the concave member (52) a hermetically sealed chamber, within which said first and second electrodes define a space (65) bounded by two plane and parallel opposing surfaces;

means for supplying RF energy to at least one of said electrodes;

characterized in that the first electrode (56) is removable from said concave member (52) via the aperture in said frame member (51) while said concave member and said frame member remain attached; and that the interior of said concave member (52) comprises a broad, shallow counterbore having a circumferential shoulder (59), against which abuts a first major surface of a first electrode (56), so as to define with concave member (52) a first cavity (61), the said first cavity (61) communicating with the outer surface of the concave member (52) by at least one passageway (73), and with the said space (65) via at least one through-bore (68), for the supply of gas to said space (65); and that the concave member (52) incorporates a second cavity (58) and a plurality of passageways (57) connecting the said second cavity with the inner surface of the concave member (52) at respective locations outside the said first cavity (61), the said second cavity (58) also communicating with the outer surface of the concave member (52) for the removal of gas from the said space (65).

2. The apparatus as set forth in claim 1 wherein said first electrode comprises a plurality of through-bores in the central portion thereof for communicating between said cavity (61) and said space (65).

3. The apparatus as set forth in claim 2 wherein said first electrode comprises a second plurality of throughbores (69) about the periphery thereof for communicating between said space (65) and said plurality of passageways (57).

4. The apparatus as set forth in claim 3 wherein said first electrode comprises a reduced thickness portion about the periphery thereof to define an annular chamber (63) between said reduced thickness portion and said concave member (52), said annular chamber interconnecting said plurality of passageways (57) and said second plurality of throughbores (69).

5. The apparatus as set forth in claim 1 wherein said circumferential shoulder (59) includes sealing means (83) for engaging said first major surface of said first electrode, thereby sealing said first cavity (61).

**Patentansprüche**

1. Plasmareaktor mit einem Rahmenelement (51) in Form einer Platte mit einer Öffnung darin, enthaltend:

ein konkaves Element (52), dessen Rand abnehmbar an einer ersten Hauptfläche des Rahmenelements (51), die genannte Öffnung umgebend, angeordnet ist;

eine erste Elektrode (56), die in dem konkaven Element (52) parallel zu dem Rahmenelement (51) angeordnet und mit dem konkaven Element (52) elektrisch verbunden ist, wobei die Querabmessungen der ersten Elektrode kleiner als die entsprechenden Querabmessungen der Öffnung sind;

Halteeinrichtungen (53, 54), die an dem konkaven Element (52) befestigt sind, um die erste Elektrode (56) festzuhalten;

eine Verschlußeinrichtung (55), an der eine zweite Elektrode befestigt ist und die dazu geeignet ist, von der entgegengesetzten Seite des Rahmenelements (51) dem konkaven Element (52) angenähert zu werden, um mit dem konkaven Element (52) eine hermetisch verschlossene Kammer auszubilden, in der die ersten und zweiten Elektroden einen Zwischenraum (65) definieren, der von zwei ebenen und parallel gegenüberstehenden Flächen begrenzt ist;

eine Einrichtung zum Zuführen von HF-Energie zu wenigstens einer der Elektroden;

dadurch gekennzeichnet, daß die erste Elektrode (56) von dem konkaven Element (52) durch die Öffnung in dem Rahmenelement (51) entfernbar ist, während das konkave Element und das Rahmenelement befestigt bleiben; und daß das Innere des konkaven Elements (52) eine breite, flache Sackbohrung enthält, die eine Umfangsschulter (59) aufweist, an die eine erste Hauptfläche einer ersten Elektrode (56) anstößt, um mit dem konkaven Element (52) einen ersten Hohlraum (61) auszubilden, der mit der Außenseite des konkaven Elements (52) durch wenigstens einen Durchlaß (73) in Verbindung steht, und mit dem genannten Zwischenraum (65) über wenigstens eine Durchgangsbohrung (68) für die Zuführung von Gas in den Zwischenraum (65) in Verbindung steht; und daß das konkave Element (52) einen zweiten Hohlraum (58) und mehrere Durchgänge (57) aufweist, die den zweiten Hohlraum mit der Innenseite des konkaven Elements (52) an entsprechenden Stellen außerhalb des ersten Hohlraums (61) verbinden, wobei der zweite Hohlraum (58) auch mit der Außenseite des konkaven Elements (52) zur Ableitung von Gas aus dem genannten Zwischenraum (65) in Verbindung steht.

2. Vorrichtung nach Anspruch 1, bei der die erste Elektrode mehrere Durchgangsbohrungen im mittleren Abschnitt derselben aufweist, um den Hohlraum (61) mit dem genannten Zwischenraum (65) zu verbinden.

3. Vorrichtung nach Anspruch 2, bei der die erste Elektrode mehrere Durchgangsbohrungen (69) um ihren Umfang aufweist, um den genannten Zwischenraum (65) mit den Durchgängen (57) zu verbinden.

4. Vorrichtung nach Anspruch 3, bei der die erste Elektrode einen Abschnitt verminderter Dicke um ihren Umfang aufweist, um eine ringförmige Kammer (63) zwischen dem Abschnitt verringerter Dicke und dem konkaven Element (52) auszubilden, die die genannten Durchlässe (57) mit den zweiten Durchgangsbohrungen (69) verbindet.

5. Vorrichtung nach Anspruch 1, bei der die Umfangsschulter (59) eine Dichtungseinrichtung (83) enthält, an der die erste Hauptfläche der ersten Elektrode anliegt, um dadurch den ersten Hohlraum (61) abzuschließen.

**Revendications**

1. Réacteur à plasma, comportant un élément châssis (51) sous la forme d'une plaque dotée d'une ouverture;

un élément concave (52) dont le bord est amoviblement attaché à une première grande surface de l'élément châssis (51), de manière à entourer ladite ouverture;

une première électrode (56) agencée dans ledit élément concave (52) auquel elle est électriquement reliée, ladite première électrode étant parallèle audit élément châssis (51) et ayant des dimensions transversales plus petites que les dimensions transversales correspondantes de ladite ouverture;

des moyens de retenue (53, 54) attachés audit élément concave (52), pour maintenir en place ladite première électrode (56);

des moyens de fermeture (55) auxquels une deuxième électrode est attachée, qui sont aptes à être rapprochés dudit élément concave (52), par le côté opposé dudit élément châssis (51), afin de définir avec l'élément concave (52) une chambre hermétiquement fermée dans laquelle lesdites première et deuxième électrode définissent un espace (65) borné par deux surfaces opposées planes et parallèles;

des moyens pour fournir de l'énergie à radiofréquence à au moins l'une desdites électrodes;

caractérisé en ce que la première électrode (56) peut être enlevée dudit élément concave (52) via l'ouverture dans ledit élément châssis (51), tandis que ledit élément concave et ledit élément châssis restent attachés; et en ce que l'intérieur dudit élément concave (52) comprend une large creusure peu profonde dotée d'un épaulement circonférentiel (59) contre lequel une première grande surface d'une première électrode (56) vient en aboutement de manière à définir, avec l'élément concave (52), une première cavité (61), cette première cavité (61) communiquant avec la surface extérieure de l'élément concave (52) par au moins un passage (73), et avec ledit espace (65) via au moins un trou traversant (68), pour fournir du gaz audit espace (65); et en ce que l'élément concave (52) comporte une deuxième cavité (58) et une pluralité de passages (57) reliant ladite deuxième cavité à la surface intérieure de l'élément concave (52) en des emplacements respectifs à l'extérieur de ladite première cavité (61), ladite deuxième cavité (58) communiquant aussi avec la surface extérieure de l'élément concave (52) pour l'enlèvement de gaz dudit espace (65).

2. Dispositif selon revendication 1, dans lequel ladite première électrode comporte une pluralité de trous traversants dans sa partie centrale, pour établir une communication entre ladite cavité (61) et ledit espace (65).

3. Dispositif selon revendication 2, dans lequel ladite première électrode comprend une deuxième pluralité de trous traversants (69) à l'entour de sa périphérie, pour établir une communication entre ledit espace (65) et ladite pluralité de passages (57).

4. Dispositif selon revendication 3, dans lequel ladite première électrode comprend une partie à épaisseur réduite à l'entour de sa périphérie, pour définir une chambre annulaire (63) entre ladite partie à épaisseur réduite et ledit élément concave (52), ladite chambre annulaire interconnectant ladite pluralité de passages (57) et ladite deuxième pluralité de trous traversants (69).

5. Dispositif selon revendication 1, dans lequel ledit épaulement circonférentiel (59) comporte des moyens d'étanchéité (83) destinés à s'appliquer contre ladite première grande surface de ladite première électrode, en assurant ainsi l'étanchéité de ladite première cavité (61).

FIG. 1 — PRIOR ART —

10

EP 0 095 200 B1

FIG. 2

EP 0 095 200 B1

*FIG. 3*